# EUROPEAN PATENT APPLICATION

(11) **EP 4 492 936 A1**
(43) Date of publication of application: **15.01.2025**
(21) Application number: 24782428.7
(22) Date of filing: 03.04.2024
(51) Int. Cl.: H05K 7/20, F28D 15/04

(54) **VAPOR CHAMBER AND ELECTRONIC DEVICE**

(30) Priority: 12.04.2023 CN 202310418150
(71) Applicant: Huawei Technologies Co., Ltd., Shenzhen, Guangdong 518129 (CN)
(72) Inventor: ZHANG, Jun, Shenzhen, Guangdong 518129 (CN); HU, Qiang, Shenzhen, Guangdong 518129 (CN); ZOU, Liujun, Shenzhen, Guangdong 518129 (CN); SHI, Jian, Shenzhen, Guangdong 518129 (CN); FENG, Chenxi, Shenzhen, Guangdong 518129 (CN)
(74) Representative: Gill Jennings & Every LLP
(86) International application number: PCT/CN2024/085746
(87) International publication number: WO 2024/212856

(57) **Abstract**

The present disclosure discloses a vapor chamber and an electronic device, and belongs to the field of heat dissipation technologies. The vapor chamber includes a housing, a first capillary structure, and a working fluid. Both the first capillary structure and the working fluid are located in the housing. An area of a projection, of the first capillary structure, on a first inner surface of the housing is less than an area of the first inner surface. The housing has a cavity. The working fluid in a liquid state is located in the first capillary structure. The working fluid in a gaseous state is located in the cavity. A region in the housing includes a first region and a second region. The first capillary structure includes a first part located in the first region and a second part located in the second region. The second part includes a trunk structure and a branch structure. The branch structure includes at least one branch. Each branch is in contact with or close to the trunk structure. According to the present disclosure, a liquid working fluid in the second region can be adsorbed in the first capillary structure as much as possible, to prevent the housing from bulging because an unabsorbed liquid working fluid freezes at a low temperature.

## Description

This application claims priority to Chinese Patent Application No. 202310418150.3, filed on April 12, 2023 and entitled "VAPOR CHAMBER AND ELECTRONIC DEVICE", which is incorporated herein by reference in its entirety.

### TECHNICAL FIELD

The present disclosure relates to the field of heat dissipation technologies, and in particular, to a vapor chamber and an electronic device.

### BACKGROUND

Vapor chambers are widely used in electronic devices, especially electronic devices with high performance and larger capacities. For example, vapor chambers are widely used in notebook computers, tablet computers, servers, and the like.

With development of electronic devices toward ultra-thinness, the vapor chamber also needs to develop toward ultra-thinness. However, a housing wall of the vapor chamber is likely to bulge as a thickness of the vapor chamber decreases. Consequently, a heat source in contact with the vapor chamber is affected.

### SUMMARY

The present disclosure provides a vapor chamber and an electronic device, to resolve a problem in a related technology that a housing wall of the vapor chamber is likely to bulge as a thickness of the vapor chamber decreases. The technical solutions are as follows:

According to a first aspect, a vapor chamber is provided. The vapor chamber includes a housing, a first capillary structure, and a working fluid. Both the first capillary structure and the working fluid are located in the housing. An area of a projection, of the first capillary structure, on a first inner surface of the housing is less than an area of the first inner surface, so that a cavity can be formed in the housing. The working fluid is converted between a gaseous state and a liquid state. The working fluid in the liquid state is located in the first capillary structure. The working fluid in the gaseous state is located in the cavity.

A region in the housing includes a first region and a second region. The first region corresponds to a region in which a heat source is located. The second region is different from the first region. The first capillary structure includes a first part located in the first region and a second part located in the second region. The second part includes a trunk structure and a branch structure. The trunk structure is connected to the first part. The branch structure corresponds to a region in which a cold source is located, and includes at least one branch. Each branch is in contact with or close to the trunk structure.

The first region corresponds to the heat source. For example, when the vapor chamber dissipates heat for the heat source, an outer surface of a housing wall, of the vapor chamber, in the first region is in contact with an outer surface of the heat source, so that heat generated when the heat source works is transferred to the housing wall located in the first region.

The second region is different from the first region. For example, the second region may be a region corresponding to the cold source. For example, the second region is a region adjacent to the cold source, and the cold source may be a fan.

The branch is in contact with the trunk structure. For example, the branch is connected to the trunk structure, and the branch is close to the trunk structure. For example, the branch is not connected to the trunk structure, and the branch may be parallel or not parallel to the trunk structure, to form an included angle.

In the solution shown in the present disclosure, the second part, of the first capillary structure, in the second region includes the trunk structure and the branch structure, and the branch structure further includes at least one branch. In this way, a liquid working fluid in the second region can be adsorbed in the first capillary structure as much as possible, to prevent an unabsorbed liquid working fluid from freezing at a low temperature. Provided that there is no freezing phenomenon in the vapor chamber in a low-temperature environment, the housing of the vapor chamber basically does not bulge, so that the vapor chamber remains in a flat state, and the heat source in contact with the vapor chamber is not affected.

For example, if the branch structure corresponds to the region in which the cold source is located, the branch structure includes at least one branch, so that the liquid working fluid in the region in which the cold source is located can be adsorbed in the first capillary structure as much as possible, to prevent an unabsorbed liquid working fluid from freezing at a low temperature.

In a possible implementation, each branch includes at least two sub-branches, and each sub-branch is connected to a branch to which the sub-branch belongs.

In the solution shown in the present disclosure, each branch may form at least two sub-branches through bifurcation. Larger quantities of sub-branches and branches indicate a larger area occupied by the first capillary structure in the second region, so that the liquid working fluid in the second region can be adsorbed in the first capillary structure as much as possible.

In a possible implementation, a capillary pore diameter of the second part located in the second region is greater than a capillary pore diameter of the first part located in the first region.

For a capillary structure, a smaller capillary pore diameter indicates a larger capillary force. In this case, the capillary structure adsorbs the liquid working fluid more easily. A smaller capillary pore diameter indicates larger backflow resistance of the liquid working fluid in the capillary structure and a smaller permeability of the capillary structure. In this case, the liquid working fluid is less likely to flow back.

In the solution shown in the present disclosure, if the capillary pore diameter of the first part is small, a capillary force is large. In this case, the liquid working fluid can be adsorbed more easily by using the large capillary force of the first part, to supplement a liquid working fluid in the first region in time. If the capillary pore diameter of the second part is large, a permeability is large. In this case, liquid return resistance of the liquid working fluid can be reduced by using the large permeability of the second part, so that the liquid working fluid flows back to the first region more easily, to supplement a liquid working fluid for the first region in time. Provided that the liquid working fluid in the first region is supplemented in time, a case in which no liquid working fluid can be evaporated in the first region can be avoided, so that the liquid working fluid that can be evaporated always exists in the first region. This can improve heat dissipation effect of the vapor chamber.

In a possible implementation, a projection area, of the first part, on a surface that is of the first inner surface and that is located in the first region is greater than a non-projection area, and the non-projection area is greater than zero.

If the non-projection area is greater than zero, it indicates that the first part does not completely occupy the surface, of the first inner surface, in the first region. If the non-projection area is equal to zero, it indicates that the first part completely occupies the surface, of the first inner surface, in the first region.

In a possible implementation, a projection area, of the first part, on a surface that is of the first inner surface and that is located in the first region is equal to an area, of the first part, on the surface that is of the first inner surface and that is located in the first region.

If the projection area, of the first part, on the surface that is of the first inner surface and that is located in the first region is equal to the area, of the first part, on the surface that is of the first inner surface and that is located in the first region, it indicates that a non-projection area is equal to zero.

For example, if the first capillary structure is directly located on the first inner surface, an area that is covered by the first part and that is of the surface, of the first inner surface, in the first region is greater than an area that is not covered by the first part.

In this way, an area occupied by the first part, of the first capillary structure, in the first region is large, so that a large quantity of liquid working fluids can be stored. In this way, it can be ensured that the liquid working fluid in the first region is always in a full state, and a case in which no liquid working fluid can be evaporated in the first region can be avoided. This can improve the heat dissipation effect of the vapor chamber.

In addition, the projection area, of the first part, on the surface that is of the first inner surface and that is located in the first region is greater than the non-projection area, so that an area occupied by the first part in the first region is large. This expands an adsorption area of the first part for adsorbing the liquid working fluid in the first region, and this also helps increase the liquid working fluid adsorbed by the first capillary structure in the first region.

In a possible implementation, the second region corresponds to the cold source, there are a plurality of second regions, and a second part is disposed in each second region.

In the solution shown in the present disclosure, the working fluid circulates in the housing, so that heat absorbed in the first region can be transferred to the plurality of second regions and dissipated. This can improve the heat dissipation effect of the vapor chamber for the heat source.

In a possible implementation, the vapor chamber includes at least two first capillary structures.

First parts of the at least two first capillary structures are located in the first region, and a second part of each first capillary structure is located in one second region.

In the solution shown in the present disclosure, there are a plurality of first capillary structures, so that a second part can be disposed in each second region.

In a possible implementation, the first parts of the at least two first capillary structures have an overlapping part in a direction parallel to the first inner surface.

For example, the first parts of the two first capillary structures that are positioned opposite to each other have the overlapping part in the first region and in the direction parallel to the first inner surface.

In the solution shown in the present disclosure, the first parts of the two first capillary structures that are positioned opposite to each other have the overlapping part, so that the projection area, of the first capillary structure, on the surface that is of the first inner surface and that is in the first region is greater than the non-projection area, to increase a storage amount of the liquid working fluid in the first region. In addition, this helps arrange a large quantity of first capillary structures in limited space in the vapor chamber.

In a possible implementation, the first parts of the at least two first capillary structures are spaced from each other in a direction parallel to the first inner surface.

For example, the two first parts that have the overlapping part are close to each other without contact.

In the solution shown in the present disclosure, the plurality of first parts located in the first region are close to each other and spaced from each other without contact, so that a heat dissipation area of the first region can be increased. This is because the liquid working fluid usually evaporates on an outer surface of the first part, and the plurality of first parts are not in contact with each other. This increases an area of the outer surface in the first region. Therefore, the heat dissipation area of the first region can be increased.

In a possible implementation, there is a gap between the first capillary structure and a second inner surface of the housing, and the second inner surface is a surface that is positioned opposite to the first inner surface.

In the solution shown in the present disclosure, because thermal resistance of heat in the gap is large, heat transfer between the first capillary structure and a housing wall on which the second inner surface is located is weak, and a temperature of the housing wall on which the second inner surface is located is not very high. In this case, a temperature difference between the housing wall on which the second inner surface is located and a housing of an electronic device is small. Therefore, when a user is in contact with the housing of the electronic device, the user basically does not feel heat. This can improve user experience during use of the electronic device.

In a possible implementation, the vapor chamber further includes a second capillary structure.

The second capillary structure completely covers the first inner surface. For example, a projection area, of the second capillary structure, on the first inner surface is equal to the area of the first inner surface.

The first capillary structure is located on a surface of the second capillary structure, and the working fluid in the liquid state is located in the first capillary structure and the second capillary structure.

In the solution shown in the present disclosure, the first capillary structure may be strip-shaped, the second capillary structure may be sheet-shaped, and an area occupied by the second capillary structure is greater than an area occupied by the first capillary structure. In this case, a liquid working fluid adsorbed in the second capillary structure is more than the liquid working fluid adsorbed in the first capillary structure, and the second capillary structure is closer to the heat source. Therefore, the second capillary structure can be used as a main heat dissipation structure of the vapor chamber, and the first capillary structure is used as a heat dissipation structure of the vapor chamber for assisting the second capillary structure. This can improve the heat dissipation effect of the vapor chamber.

In a possible implementation, a capillary pore diameter of a part, of the second capillary structure, in the second region is greater than a capillary pore diameter of a part, of the second capillary structure, in the first region.

In the solution shown in the present disclosure, the second capillary structure has a small capillary pore diameter in the first region and has a large capillary pore diameter in the second region, so that a capillary force and a permeability of the second capillary structure can be balanced, and the second capillary structure has a large capillary force in the first region and has a large permeability in the second region.

In this way, the liquid working fluid adsorbed by the second capillary structure in the second region can easily flow back to the first region, and the liquid working fluid is easily adsorbed in the first region.

In a possible implementation, a capillary pore diameter of the first capillary structure is different from a capillary pore diameter of the second capillary structure.

In the solution shown in the present disclosure, to further balance the capillary force and the permeability, capillary pore diameters of the first capillary structure and the second capillary structure may alternatively be different correspondingly.

For example, the capillary pore diameter of the first capillary structure may be greater than the capillary pore diameter of the second capillary structure. For another example, the capillary pore diameter of the first capillary structure may be less than the capillary pore diameter of the second capillary structure.

In a possible implementation, the second capillary structure is made of foam metal.

The foam metal may be foam copper.

In the solution shown in the present disclosure, the foam metal is a multi-layer stacked structure. Correspondingly, in an example, the first capillary structure may be made of foam metal (for example, foam copper). During manufacturing, different pore-forming agents may be selected, so that capillary pore diameters of the first capillary structure at different positions are different. For example, when the first capillary structure is processed by using the foam metal, a pore-forming agent with a small pore diameter may be selected to process the first part, and a pore-forming agent with a large pore diameter may be selected to process the second part. In this way, the capillary pore diameter of the processed first part of the first capillary structure is less than the capillary pore diameter of the second part.

In a possible implementation, the first capillary structure is made of foam metal (for example, foam copper).

In the solution shown in the present disclosure, the second capillary structure may also be made of foam metal (for example, foam copper). During manufacturing, the second capillary structure with a large capillary pore diameter and a small capillary pore diameter may also be processed by using pore-forming agents with different pore diameters, so that the capillary pore diameter of the part, of the second capillary structure, in the second region is greater than the capillary pore diameter of the part, of the second capillary structure, in the first region.

In a possible implementation, the first capillary structure is a multi-layer stacked structure.

In a possible implementation, the second capillary structure is a multi-layer stacked structure.

In a possible implementation, the multi-layer stacked structure is a preformed multi-layer stacked structure.

In the solution shown in the present disclosure, preforming means that the multi-layer stacked structure is preprocessed before the vapor chamber is processed, and then, the multi-layer stacked structure is cut into a required shape based on a size of the vapor chamber.

In a possible implementation, a processing manner of the multi-layer stacked structure is one of calendering, silk-screen printing, 3D printing, and electroplating.

According to a second aspect, a vapor chamber is further provided. The vapor chamber includes a housing, a first capillary structure, a working fluid, and a third capillary structure. The first capillary structure, the working fluid, and the third capillary structure are all located in the housing. An area of a projection, of the first capillary structure, on a first inner surface of the housing is less than an area of the first inner surface. The housing has a cavity. The working fluid is converted between a gaseous state and a liquid state. The working fluid in the liquid state is located in the first capillary structure and the third capillary structure. The working fluid in the gaseous state is located in the cavity.

A region in the housing includes a first region and a second region. The first region corresponds to a region in which a heat source is located. The second region is different from the first region. The first capillary structure includes a first part and a second part. The first part is located in the first region. Both the second part and the third capillary structure are located in the second region. The second part is in contact with or close to the third capillary structure.

In the solution shown in the present disclosure, not only the second part of the first capillary structure is disposed in the second region, but also the third capillary structure is disposed in the second region. An area occupied by capillary structures in the second region is large. In this way, a liquid working fluid in the second region can be adsorbed in the first capillary structure as much as possible, to prevent an unabsorbed liquid working fluid from freezing at a low temperature. Provided that there is no freezing phenomenon in the vapor chamber in a low-temperature environment, the housing of the vapor chamber basically does not bulge, so that the vapor chamber remains in a flat state, and the heat source in contact with the vapor chamber is not affected.

In a possible implementation, the vapor chamber further includes a second capillary structure.

The second capillary structure completely covers the first inner surface. Both the first capillary structure and the third capillary structure are located on a surface of the second capillary structure. The working fluid in the liquid state is located in the first capillary structure, the second capillary structure, and the third capillary structure.

In the solution shown in the present disclosure, the first capillary structure and the third capillary structure may be strip-shaped, the second capillary structure may be sheet-shaped, and an area occupied by the second capillary structure is greater than a sum of an area occupied by the first capillary structure and an area occupied by the third capillary structure. In this case, a liquid working fluid adsorbed in the second capillary structure is more than liquid working fluids adsorbed in the first capillary structure and the third capillary structure, and the second capillary structure is closer to the heat source. Therefore, the second capillary structure can be used as a main heat dissipation structure of the vapor chamber, and the first capillary structure and the third capillary structure are used as heat dissipation structures of the vapor chamber for assisting the second capillary structure. This can improve heat dissipation effect of the vapor chamber.

According to a third aspect, an electronic device is further provided. The electronic device includes a heat source and the vapor chamber according to the first aspect or the second aspect. A first housing wall of the vapor chamber is in contact with the heat source at a position corresponding to a first region. The first housing wall is a housing wall corresponding to a first inner surface.

The housing wall corresponding to the first inner surface may be, for example, a housing wall on which the first inner surface is located.

As described above, a second part, of a first capillary structure of the vapor chamber of the electronic device, in a second region includes a trunk structure and a branch structure, and the branch structure further includes at least one branch. In this way, a liquid working fluid in the second region can be adsorbed in the first capillary structure as much as possible, to prevent an unabsorbed liquid working fluid from freezing at a low temperature. Provided that there is no freezing phenomenon in the vapor chamber in a low-temperature environment, the housing of the vapor chamber basically does not bulge, so that the vapor chamber remains in a flat state, and the heat source in contact with the vapor chamber is not affected.

For example, if the branch structure corresponds to a region in which a cold source is located, the branch structure includes at least one branch, so that a liquid working fluid in the region in which the cold source is located can be adsorbed in the first capillary structure as much as possible, to prevent an unabsorbed liquid working fluid from freezing at a low temperature.

In addition, because the second part, of the first capillary structure, in the second region includes the trunk structure and the branch structure, and the branch structure further includes at least one branch, an area occupied by the first capillary structure in the second region can be increased, and an adsorption range in which the first capillary structure adsorbs the liquid working fluid in the second region can be increased, so that liquid working fluids at a large quantity of positions or even all positions in the second region can be adsorbed. This further reduces or even eliminates the unabsorbed liquid working fluid in the second region.

In addition, the first capillary structure adsorbs a large quantity of liquid working fluids in the second region, so that the liquid working fluid can be supplemented for the first region in time. In this way, a case in which no liquid working fluid can be evaporated in the first region is avoided, so that the liquid working fluid that can be evaporated always exists in the first region. This can improve heat dissipation effect of the vapor chamber.

### BRIEF DESCRIPTION OF DRAWINGS

FIG. 1 is a diagram of a structure of a cross section, in a thickness direction, of a vapor chamber according to the present disclosure;
FIG. 2 is a schematic top view of a structure of a vapor chamber according to the present disclosure;
FIG. 3 is a diagram of a structure of a first capillary structure located in a housing according to the present disclosure;
FIG. 4 is a diagram of a relationship between a trunk structure and a branch that are of a second part of a first capillary structure according to the present disclosure;
FIG. 5 is a diagram of a relationship between a trunk structure and a branch that are of a second part of a first capillary structure according to the present disclosure;
FIG. 6 is a diagram of a relationship between a trunk structure and a branch that are of a second part of a first capillary structure according to the present disclosure;
FIG. 7 is a diagram of a relationship between a trunk structure and a branch that are of a second part of a first capillary structure according to the present disclosure;
FIG. 8 is a diagram of a relationship between a trunk structure and a branch that are of a second part of a first capillary structure according to the present disclosure;
FIG. 9 is a diagram of a structure of a first capillary structure located in a housing according to the present disclosure;
FIG. 10 is a diagram of a structure of a first capillary structure and a second capillary structure that are located in a housing according to the present disclosure;
FIG. 11 is a diagram of a structure of a cross section, in a thickness direction, of a vapor chamber according to the present disclosure; and
FIG. 12 is a diagram of a structure of a first capillary structure, a third capillary structure, and a second capillary structure that are located in a housing according to the present disclosure.

### Reference numerals:

1: housing; 10: cavity; 11: first region; 12: second region; 13: upper cover; 14: base; 2: first capillary structure; 21: first part; 22: second part; 221: trunk structure; 222: branch structure; 223: branch; 224: sub-branch; 3: second capillary structure; 4: third capillary structure.

### DESCRIPTION OF EMBODIMENTS

Although the present disclosure is described with reference to some embodiments, this does not mean that features of this application are limited only to the implementations. On the contrary, an objective of describing this application with reference to implementations is to cover another option or modification that may be derived based on claims of the present disclosure. To provide an in-depth understanding of the present disclosure, the following descriptions include a plurality of specific details. The present disclosure may alternatively be implemented without using these details. In addition, to avoid confusing or blurring a focus of the present disclosure, some specific details are omitted from the descriptions. It should be noted that embodiments in the present disclosure and the features in embodiments may be mutually combined in the case of no conflict.

Embodiments provide a vapor chamber (vapor chamber, VC). The vapor chamber is also referred to as a vapor chamber, and mainly includes a housing, a capillary structure, and a working fluid. The housing includes an upper cover and a base, the upper cover and the base are fastened to form a sealed vacuum cavity, and both the capillary structure and the working fluid are located in the vacuum cavity.

The capillary structure is a fine structure having a capillary phenomenon. The capillary phenomenon includes a phenomenon that infiltration liquid rises in a capillary and a phenomenon that non-infiltration liquid falls in a capillary.

The working fluid, for example, may be water.

In the vacuum cavity of the housing, a temperature at which phase transition occurs in the working fluid is low. For example, a liquid working fluid may evaporate at a low temperature and is converted into a gaseous working fluid, and the gaseous working fluid condenses when the gaseous working fluid cools, and is converted into the liquid working fluid.

The capillary structure adsorbs the liquid working fluid through the capillary phenomenon, and the capillary structure does not completely occupy the vacuum cavity, so that the vacuum cavity has a cavity, and the gaseous working fluid can flow in the cavity.

Based on the foregoing structural feature of the vapor chamber, a principle in which the vapor chamber dissipates heat for a heat source may be that a first region of the vapor chamber is in contact with the heat source, a large amount of heat is generated when the heat source works, and the heat is transferred from the heat source to the first region of the vapor chamber, so that the liquid working fluid in the capillary structure evaporates after being heated, and is converted into the gaseous working fluid. In the phase transition process, a large amount of heat may be absorbed, to dissipate heat for the heat source. Therefore, the first region may be referred to as an evaporation region because the liquid working fluid evaporates.

The gaseous working fluid generated in the first region of the vapor chamber flows in the cavity. When the gaseous working fluid flows to a cold second region, the gaseous working fluid condenses into the liquid working fluid in the second region. In the phase transition process, heat is released, and the heat absorbed in the first region is released in the second region. Therefore, the second region may be referred to as a condensation region because the liquid working fluid condenses.

The liquid working fluid generated in the second region of the vapor chamber is adsorbed in the capillary structure, and flows back to the first region through the capillary phenomenon of the capillary structure.

The foregoing process is repeatedly performed in the vapor chamber, to dissipate heat for the heat source.

The vapor chamber is widely used in electronic devices, for example, used in devices such as a mobile phone, a notebook computer, and a tablet computer, to dissipate heat for a heat source in the electronic device, for example, dissipate heat for a chip in the electronic device.

With development of electronic devices toward ultra-thinness, the vapor chamber also develops toward ultra-thinness. However, at least the following problems are faced as a thickness of the vapor chamber decreases.

First, a cross section of the capillary structure becomes smaller. This increases resistance of the liquid working fluid to flow from the second region to the first region. Consequently, a large quantity of liquid working fluids gathers in the second region, the capillary structure in the second region is in a supersaturated state, and liquid working fluids that are not absorbed by the capillary structure exist in the second region. These liquid working fluids freeze at a low temperature, for example, in winter with a low temperature. Compared with the liquid working fluid, a solid working fluid has a larger volume, and space of the vacuum cavity of the vapor chamber is small. Consequently, an outer surface of the vapor chamber bulges. The outer surface of the vapor chamber is in contact with the heat source, and a bulge on the outer surface of the vapor chamber may damage the heat source.

Second, because the large quantity of liquid working fluids gather in the second region, fewer liquid working fluids flow back to the first region, and a possibility that the liquid working fluids in the first region completely evaporate occurs. Consequently, circulation of the working fluids in the vacuum cavity is interrupted, and heat dissipation effect of the vapor chamber is reduced.

According to the vapor chamber shown in embodiments, a phenomenon that the liquid working fluids gather in the second region can be improved, and the heat dissipation effect of the vapor chamber can be improved.

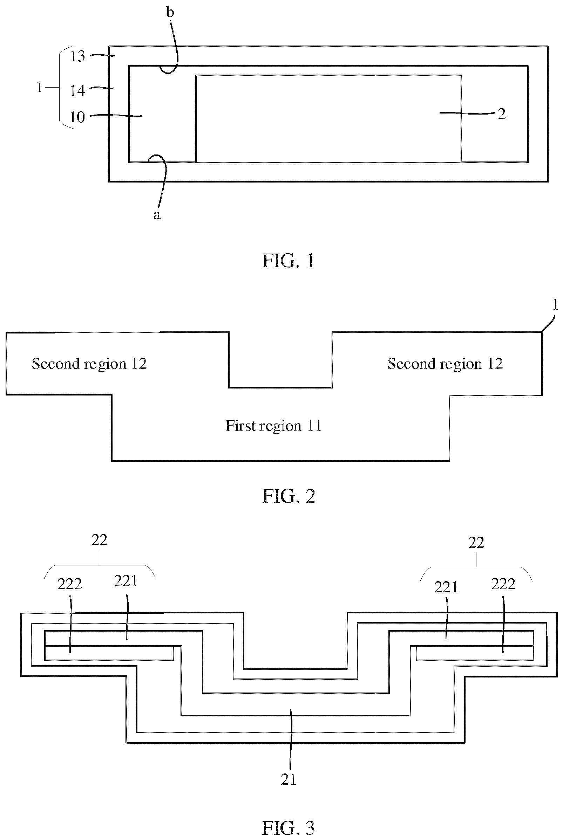

As shown in FIG. 1, the vapor chamber includes a housing 1, a first capillary structure 2, and a working fluid. Both the first capillary structure 2 and the working fluid are located in the housing 1. For a structure of the housing 1, refer to FIG. 1. The housing 1 includes an upper cover 13 and a base 14. The upper cover 13 covers a side wall of the base 14, to form a sealed cavity, and then the sealed cavity is vacuumized, to form a vacuum cavity.

To form a cavity for a gaseous working fluid to flow in the housing 1, as shown in FIG. 1, an area of a projection, of the first capillary structure 2, on a first inner surface a of the housing 1 is less than an area of the first inner surface a. The first inner surface a may be an inner surface of a housing wall of the housing 1, for example, may be an inner surface of the upper cover 13, or may be an inner surface of the base 14. As shown in FIG. 1, the inner surface of the base 14 may be denoted as the first inner surface a, and the inner surface of the upper cover 13 may be denoted as a second inner surface b.

In this way, because the area of the orthographic projection, of the first capillary structure 2, on the first inner surface a is less than the area of the first inner surface a, a cavity 10 may be formed between an outer surface of the first capillary structure 2 and an inner surface of the housing 1, and the working fluid in a gaseous state may flow in the cavity 10.

Further, the working fluid is converted between a gaseous state and a liquid state in the housing 1, and the gaseous working fluid and the liquid working fluid may coexist in the housing 1. The working fluid in the liquid state may be located in the first capillary structure 2. For example, the working fluid flows in the first capillary structure 2 by using a capillary force. The working fluid in the gaseous state may be located in the cavity 10. For example, the gaseous working fluid may flow in the cavity 10.

Refer to FIG. 2. A region in the housing 1 may include a first region 11 and a second region 12. The first region 11 corresponds to a region in which a heat source is located. The second region 12 is a region different from the first region 11. FIG. 2 is a schematic top view of a structure of the vapor chamber.

For example, the second region 12 may be a region corresponding to a cold source. For another example, the second region 12 may be a region other than the first region 11. For ease of description, an example in which the second region 12 is the region corresponding to the cold source may be used.

It should be noted that the first region 11 that is of the vapor chamber and that corresponds to the heat source means that during application of the vapor chamber, a position of the first region 11 of the vapor chamber is opposite to a position of the heat source. For example, an outer surface of the vapor chamber is in close contact with an outer surface of the heat source at a position corresponding to the first region 11. The second region 12 that is of the vapor chamber and that corresponds to the cold source may mean that during application of the vapor chamber, the second region 12 of the vapor chamber is adjacent to the cold source, for example, adjacent to a fan.

To enable a liquid working fluid in the second region 12 to flow back to the first region 11 by using the first capillary structure 2, correspondingly, the first capillary structure 2 includes a first part 21 and a second part 22. The first part 21 is located in the first region 11. The second part 22 is located in the second region 12. The first part 21 is connected to the second part 22. In this way, the second part 22 located in the second region 12 enables the adsorbed liquid working fluid to flow back to the first part 21 located in the first region 11.

To enable the liquid working fluid in the second region 12 to be adsorbed in the first capillary structure 2 as much as possible, correspondingly, as shown in FIG. 3, the second part 22 that is of the first capillary structure 2 and that is located in the second region 12 may include a trunk structure 221 and a branch structure 222. As described above, the second region 12 may correspond to the region in which the cold source is located, and the trunk structure 221 and the branch structure 222 may correspond to the region in which the cold source is located.

Because a large quantity of parts of the first capillary structure 2 are located in the second region 12, the liquid working fluid in the second region 12 can be adsorbed in the first capillary structure 2 as much as possible, to prevent an unabsorbed liquid working fluid from freezing at a low temperature.

In addition, because a large quantity of parts of the first capillary structure 2 are located in the second region 12, an area occupied by the first capillary structure 2 in the second region 12 can be increased, and an adsorption range in which the first capillary structure 2 adsorbs the liquid working fluid in the second region 12 can be increased, so that liquid working fluids at a large quantity of positions in the second region 12 can be adsorbed. This further reduces the unabsorbed liquid working fluid in the second region 12.

In addition, the first capillary structure 2 adsorbs a large quantity of liquid working fluids in the second region 12, so that the liquid working fluid can be supplemented for the first region 11 in time. In this way, a case in which no liquid working fluid can be evaporated in the first region 11 is avoided. This can improve heat dissipation effect of the vapor chamber.

To enable the liquid working fluids adsorbed by the trunk structure 221 and the branch structure 222 that are located in the second region 12 to flow back to the first part 21 located in the first region 11, correspondingly, the trunk structure 221 is connected to the first part 21, and a liquid working fluid adsorbed by the branch structure 222 can flow to the trunk structure 221. In this way, the liquid working fluid adsorbed by the trunk structure 221 can flow to the first part 21.

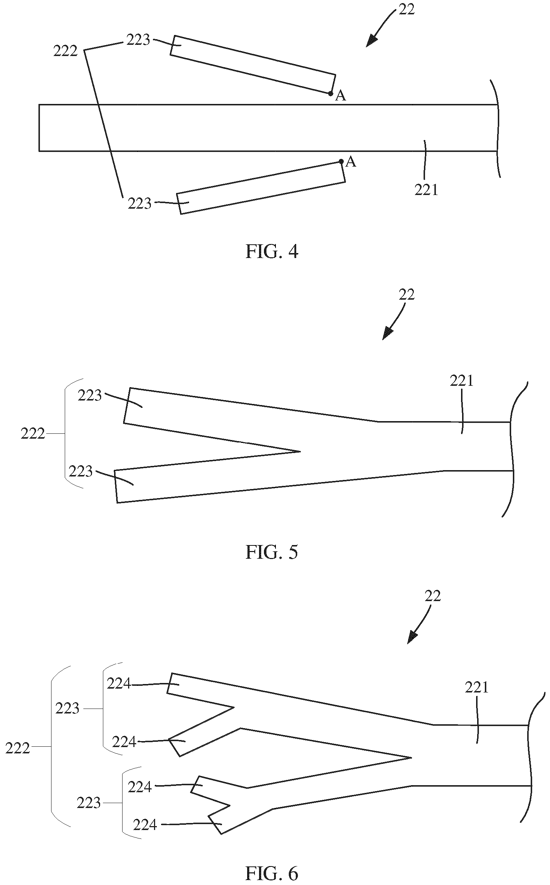

To enable the liquid working fluid adsorbed by the branch structure 222 to flow back to the trunk structure 221, correspondingly, a manner may be that, as shown in FIG. 3, the branch structure 222 may be in contact with the trunk structure 221. Another manner may be that, as shown in FIG. 4, the branch structure 222 is close to the trunk structure 221, so that a part or all of the branch structure 222 is located within an adsorption range of the trunk structure 221. In this way, the trunk structure 221 adsorbs the liquid in the branch structure 222.

The branch structure 222 is in contact with the trunk structure 221. In other words, the branch structure 222 is connected to the trunk structure 221. The branch structure 222 is close to the trunk structure 221. In other words, the branch structure 222 is not connected to the trunk structure 221, and there is a gap between the branch structure 222 and the trunk structure 221. For example, the strip-shaped branch structure 222 and the strip-shaped trunk structure 221 may be parallel, or may have an included angle as shown in FIG. 4.

The branch structure 222 is close to the trunk structure 221. For example, as shown in FIG. 4, the branch structure 222 is at a position A, and is closest to the trunk structure 221. In this case, the position A of the branch structure 222 is in the adsorption range of the trunk structure 221, so that the liquid working fluid adsorbed by the branch structure 222 is adsorbed by the trunk structure 221.

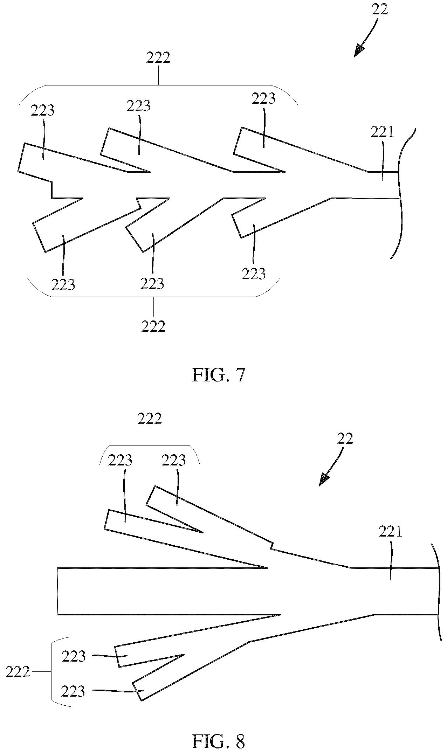

In an example, the branch structure 222 includes at least one branch. For example, as shown in FIG. 3, the branch structure 222 includes one branch 223. For another example, as shown in FIG. 4 to FIG. 6, the branch structure 222 includes two branches 223. For another example, as shown in FIG. 7 and FIG. 8, the branch structure 222 includes more than two branches 223. Refer to FIG. 3 to FIG. 8. Each branch 223 is in contact with or close to the trunk structure 221.

In an example, as shown in FIG. 3, the branch structure 222 includes one branch. The trunk structure 221 and the branch structure 222 may be strip-shaped, and the trunk structure 221 and the branch structure 222 may be located in the second region 12 side by side. For example, the trunk structure 221 and the branch structure 222 may be arranged side by side in a width direction of the trunk structure 221. The main part 221 and the branch structure 222 may be in contact with each other, or may have a spacing.

In an example, as shown in FIG. 5 and FIG. 6, the trunk structure 221 is strip-shaped, and the branch 223 of the branch structure 222 may be formed by the trunk structure 221 through at least one bifurcation at a position close to an end of the trunk structure 221.

For example, as shown in FIG. 5, the trunk structure 221 performs bifurcation once at the position close to the end, to form two branches 223. For another example, as shown in FIG. 6, the trunk structure 221 performs bifurcation once at the position close to the end, to form two branches 223, and each branch 223 performs bifurcation once again, to form two sub-branches 224.

Therefore, the branch 223 may include at least two sub-branches 224, and each sub-branch 224 may be connected to or close to a branch 223 to which the sub-branch 224 belongs.

In an example, as shown in FIG. 7 and FIG. 8, the trunk structure 221 is strip-shaped, and at least one branch 223 of the branch structure 222 may be located on a side part of the trunk structure 221 in the width direction.

For example, refer to FIG. 7. A plurality of branches 223 may be disposed on one side of the trunk structure 221 in the width direction, and the plurality of branches 223 may not be in contact with each other. For another example, as shown in FIG. 7, a plurality of branches 223 are disposed on both a first side and a second side of the trunk structure 221 that are in the width direction. For another example, as shown in FIG. 8, a side part of the trunk structure 221 in the width direction has a plurality of branches 223, and branches 223 located on a same side may be in contact with each other.

A manner of forming at least one branch 223 of the branch structure 222 and a position relationship relative to the trunk structure 221 are not specifically limited in this embodiment.

In an example, parameters that affect flow of the liquid working fluid in the first capillary structure 2 mainly include a capillary force and a permeability of the first capillary structure 2. A larger capillary force indicates better adsorption effect of the first capillary structure 2. In this case, the first capillary structure 2 adsorbs the liquid working fluid more easily. A higher permeability indicates smaller backflow resistance of the liquid working fluid in the first capillary structure 2. In this case, the liquid working fluid flows back to the first region 11 more easily.

Both the capillary force and the permeability are related to a capillary pore diameter of the first capillary structure 2. For example, a smaller capillary pore diameter indicates a larger capillary force but a lower permeability.

Therefore, to balance the capillary force and the permeability of the first capillary structure 2, a capillary pore diameter of the first part 21, of the first capillary structure 2, in the first region 11 may be small, to increase the capillary force, and a capillary pore diameter of the second part 22 in the second region 12 may be large, to increase the permeability.

Correspondingly, the capillary pore diameter of the second part 22 of the first capillary structure 2 may be greater than the capillary pore diameter of the first part 21.

In this way, the first part 21 adsorbs the liquid working fluid more easily by using a large capillary force of the first part 21, to supplement the liquid working fluid in the first region 11 in time, and liquid return resistance of the liquid working fluid is reduced in the second part 22 by using a large permeability of the second part 22, so that the liquid working fluid flows back to the first region 11 more easily, to supplement a liquid working fluid for the first region 11 in time. Provided that the liquid working fluid in the first region 11 is supplemented in time, a case in which no liquid working fluid can be evaporated in the first region 11 can be avoided, so that the liquid working fluid that can be evaporated always exists in the first region 11. This can improve heat dissipation effect of the vapor chamber.

In an example, in a solution in which the first region 11 corresponds to the heat source, and the second region 12 corresponds to the cold source, there is a transition region between the first region 11 and the second region 12, and the transition region may also be referred to as an adiabatic region. In this case, a part of the first capillary structure 2 may also be located in the transition region, and a capillary pore diameter of a third part, of the first capillary structure 2, in the transition region may also be large, to improve the permeability, reduce the liquid return resistance of the liquid working fluid, and supplement a liquid working fluid for the first region 11 in time.

For example, the capillary pore diameter of the part, of the first capillary structure 2, in the transition region may be equal to the capillary pore diameter of the second part 22 in the second region 12, and both are greater than the capillary pore diameter of the first part 21 in the first region 11.

In an example, to supplement the liquid working fluid adsorbed by the first capillary structure 2 in the second region to the first region 11 in time, correspondingly, the third part, of the first capillary structure 2, in the transition region may be wide, to reduce the liquid return resistance of the liquid working fluid, so that the liquid working fluid adsorbed by the first capillary structure 2 in the second region 12 easily passes through the transition region and flows back to the first region 11.

In an example, the liquid working fluid adsorbed by the first capillary structure 2 in the first region 11 may be increased, to ensure that the liquid working fluid in the first region 11 is sufficient. Correspondingly, the first inner surface a includes a surface located in the first region 11 and a surface located in the second region 12. A projection area, of the first part 21, on the surface located in the first region 11 is greater than a non-projection area, and the non-projection area is greater than or equal to zero.

If the non-projection area is greater than zero, it indicates that the first part 21 does not completely occupy the surface, of the first inner surface a, in the first region 11. If the non-projection area is equal to zero, it indicates that the first part 21 completely occupies the surface, of the first inner surface a, in the first region 11.

For example, if the first capillary structure 2 is directly located on the first inner surface a, an area that is covered by the first part 21 and that is of the surface, of the first inner surface a, in the first region 11 is greater than an area that is not covered by the first part 21.

In this way, an area occupied by the first part 21, of the first capillary structure 2, in the first region 11 is large, so that a large quantity of liquid working fluids can be stored. In this way, it can be ensured that the liquid working fluid in the first region 11 is always in a full state, and a case in which no liquid working fluid can be evaporated in the first region 11 can be avoided. This can improve the heat dissipation effect of the vapor chamber.

In addition, the projection area, of the first part 21, on the surface that is of the first inner surface a and that is located in the first region 11 is greater than the non-projection area, so that an area occupied by the first part 21 in the first region 11 is large. This expands an adsorption area of the first part 21 for adsorbing the liquid working fluid in the first region 11, and this also helps increase the liquid working fluid adsorbed by the first capillary structure 2 in the first region 11.

In an example, an implementation in which the projection area, of the first part 21, on the surface that is of the first inner surface a and that is located in the first region 11 is greater than the non-projection area may be that a width of the first part 21 located in the first region 11 may be wide, that is, the width of the first part 21 is widened.

Another implementation may be that a sub-part is disposed around the first part 21. For example, the sub-part may be disposed on a side part, of the first part 21, in a width direction. The first part 21 and the sub-part may be in contact with or close to each other. If the first part 21 and the sub-part are close to each other, the liquid working fluid adsorbed by the first part 21 may flow to the sub-part, so that the sub-part can pull the liquid working fluid from the second part 22 through the first part 21.

Another implementation may be that there are a plurality of first capillary structures 2, and first parts 21 of the plurality of first capillary structures 2 are all located in the first region 11. In this way, the area occupied by the first parts 21 in the first region 11 can also be increased.

In an example, to improve the heat dissipation effect of the vapor chamber for the heat source, a plurality of regions of the vapor chamber usually correspond to the cold source. Correspondingly, there may be a plurality of second regions 12 corresponding to the cold source. A second part 22 of the first capillary structure 2 may be disposed in each second region 12. In this way, the working fluid circulates in the housing, so that heat absorbed in the first region can be transferred to the plurality of second regions 12 and dissipated.

For example, refer to FIG. 2. There are two second regions 12, and the two second regions 12 are located on two sides of the first region 11 that are positioned opposite to each other.

Certainly, there may be more second regions 12. For ease of description, two second regions 12 may be used as an example in this embodiment.

In an example, a plurality of second parts 22 may belong to a same capillary structure. For example, as shown in FIG. 3, the first capillary structure 2 includes a plurality of second parts 22. A quantity of second parts 22 may be equal to a quantity of second regions 12.

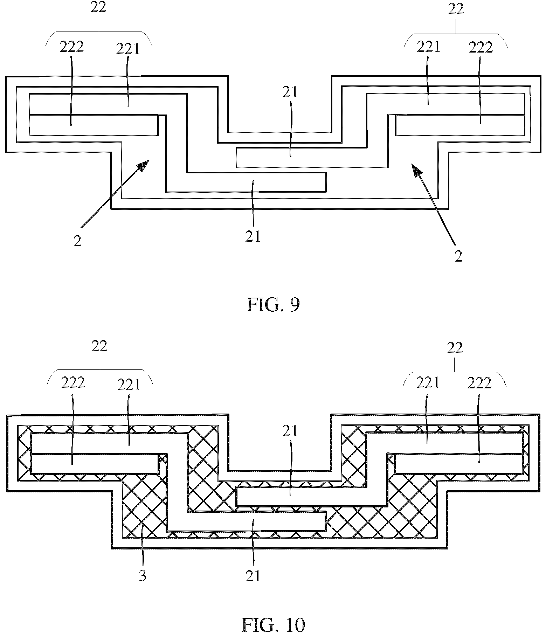

In another example, the plurality of second parts 22 may alternatively belong to different capillary structures. For example, refer to FIG. 9. There are at least two first capillary structures 2. First parts 21 of the at least two first capillary structures 2 are located in the first region 11, and a second part 22 of each first capillary structure 2 is located in one second region 12.

For example, as shown in FIG. 9, there are two second regions 12, and there are also two first capillary structures 2. First parts 21 of the two first capillary structures 2 are both located in the first region 11, a second part 22 of one first capillary structure 2 is located in one second region 12, and a second part 22 of the other first capillary structure 2 is located in the other second region 12.

In an example, the first parts 21 of the two first capillary structures 2 that are positioned opposite to each other may have an overlapping part in the first region 11 and in a direction parallel to the first inner surface a.

For example, the first parts 21 of the two first capillary structures 2 that are positioned opposite to each other have the overlapping part in a width direction of the first part 21.

The first parts 21 of the two first capillary structures 2 that are positioned opposite to each other have the overlapping part, so that the projection area, of the first capillary structure 2, on the surface that is of the first inner surface a and that is in the first region 11 is greater than the non-projection area, to increase a storage amount of the liquid working fluid in the first region 11. In addition, this helps arrange a large quantity of first capillary structures 2 in limited space in the vapor chamber.

In an example, the two first parts 21 that have the overlapping part may be in contact with or close to each other. For example, as shown in FIG. 9, the two first parts 21 are close to each other.

For example, the first parts 21 of the at least two first capillary structures 2 are spaced from each other in a direction parallel to the first inner surface a.

In an example, refer to FIG. 9. The plurality of first parts 21 located in the first region 11 are spaced from each other and close to each other without contact, so that a heat dissipation area of the first region 11 can be increased. This is because the liquid working fluid usually evaporates on an outer surface of the first part 21, and the plurality of first parts 21 are not in contact with each other. This increases an area of the outer surface in the first region 11. Therefore, the heat dissipation area of the first region 11 can be increased.

Similarly, at least one sub-part is disposed near the first part 21. If adjacent sub-parts are not in contact with each other, and the sub-parts are not in contact with the first part 21, the heat dissipation area of the first region 11 can also be increased.

In an example, the first capillary structure 2 may be a multi-layer stacked structure, for example, may be a preformed multi-layer stacked structure.

A quantity of capillaries in the capillary structure may be increased by using the multi-layer stacked structure. A larger quantity of capillaries indicates a larger adsorption amount of the capillary structure. Therefore, the first capillary structure 2 uses the multi-layer stacked structure, so that an adsorption amount of the first capillary structure 2 can be increased.

Preforming means that the multi-layer stacked structure is preprocessed before the vapor chamber is processed, and then, the multi-layer stacked structure is cut into a required shape based on a size of the vapor chamber.

In an example, the multi-layer stacked structure may be implemented in a processing manner, for example, calendering, silk-screen printing, 3D printing, and electroplating.

Foam metal is a multi-layer stacked structure, for example, foam copper. Correspondingly, in an example, the first capillary structure 2 may be made of foam metal. During manufacturing, different pore-forming agents may be selected, so that capillary pore diameters of the first capillary structure 2 at different positions are different. For example, when the first capillary structure 2 is processed by using the foam metal, a pore-forming agent with a small pore diameter may be selected to process the first part 21, and a pore-forming agent with a large pore diameter may be selected to process the second part 22. In this way, the capillary pore diameter of the processed first part 21 of the first capillary structure 2 is less than the capillary pore diameter of the second part 22.

Certainly, the first capillary structure 2 may alternatively be a multi-layer stacked structure formed by a metal mesh (for example, a copper mesh), or may be a multi-layer stacked structure formed by a braided wire bundle made of a metal material, or may be a multi-layer stacked structure formed by metal powder (for example, copper powder) through sintering, or may be a counter-layer stacked structure formed by metal powder slurry (for example, copper powder slurry).

In an example, the vapor chamber is disposed in an electronic device. An outer surface of a housing wall on which the first inner surface a of the housing is located is usually in contact with an outer surface of the heat source, and a housing wall on which the second inner surface b of the housing is located is usually close to a housing of the electronic device, for example, a bottom housing. Positions of the first inner surface a and the second inner surface b of the housing 1 are opposite. To weaken heat transfer between the vapor chamber and the housing and improve user experience, there may be a gap between the first capillary structure 2 and the second inner surface b of the housing 1, as shown in FIG. 10.

In this way, because thermal resistance of heat in the gap is large, heat transfer between the first capillary structure 2 and the housing wall on which the second inner surface b is located is weak, and a temperature of the housing wall on which the second inner surface b is located is not very high. In this case, a temperature difference between the housing wall on which the second inner surface b is located and the housing of the electronic device is small. Therefore, when a user is in contact with the housing of the electronic device, the user basically does not feel heat. This can improve user experience during use of the electronic device.

The foregoing describes a feature of the first capillary structure 2 of the vapor chamber.

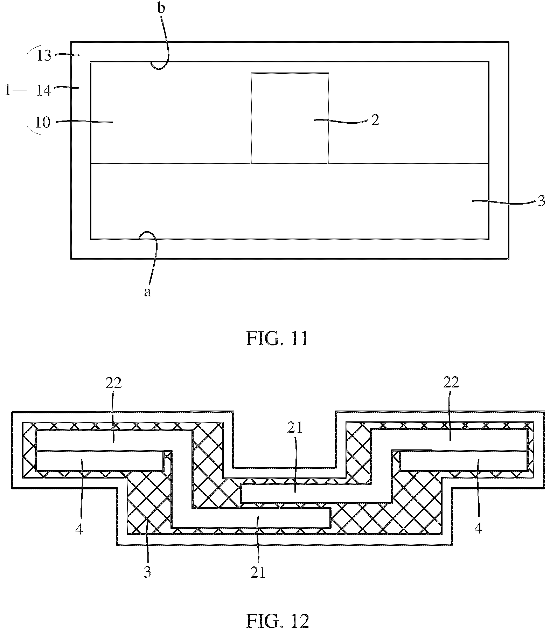

In another example, to improve the heat dissipation effect of the vapor chamber, correspondingly, as shown in FIG. 10 and FIG. 11, the vapor chamber may further include a second capillary structure 3. The second capillary structure 3 is located on the first inner surface a, and a projection area, of the second capillary structure 3, on the first inner surface a is equal to the area of the first inner surface a. In other words, the second capillary structure 3 completely covers the first inner surface a. In FIG. 10, a grid-filled part is an example of the second capillary structure 3 located on the first inner surface a.

The first capillary structure 2 is located on a surface of the second capillary structure 3, and the liquid working fluid may flow in the first capillary structure 2 and the second capillary structure 3.

In an example, as shown in FIG. 10, the first capillary structure 2 may be strip-shaped, the second capillary structure 3 may be sheet-shaped, and an area occupied by the second capillary structure 3 is greater than an area occupied by the first capillary structure 2. In this case, a liquid working fluid adsorbed in the second capillary structure 3 is more than the liquid working fluid adsorbed in the first capillary structure 2, and the second capillary structure 3 is closer to the heat source. Therefore, the second capillary structure 3 can be used as a main heat dissipation structure of the vapor chamber, and the first capillary structure 2 is used as a heat dissipation structure of the vapor chamber for assisting the second capillary structure 3.

It should be noted that, in a solution in which the vapor chamber includes the second capillary structure 3, the projection area, of the first part 21, on the surface that is of the first inner surface a and that is located in the first region 11 is greater than the non-projection area, and the non-projection area is not zero.

This is because, as described above, if the non-projection area is greater than zero, it indicates that the first part 21 does not completely occupy a surface, of the second capillary structure 3, in the first region 11, and if the non-projection area is equal to zero, it indicates that the first part 21 completely occupies the surface, of the second capillary structure 3, in the first region 11. If the first part 21 occupies all positions of the second capillary structure 3 in the first region 11, heat of the heat source is first transferred to the housing wall on which the first inner surface a is located, transferred to the second capillary structure 3, transferred to the first capillary structure 2, and then is dissipated to the outside. A heat dissipation path is long, and the heat dissipation effect for the heat source is reduced. Therefore, in a solution in which there is the second capillary structure 3, the projection area, of the first capillary structure 2, on the surface that is of the first inner surface a and that is located in the first region 11 needs to be less than an area of the surface that is of the first inner surface a and that is located in the first region 11. In other words, the first part 21 does not completely cover the surface, of the second capillary structure 3, in the first region 11.

In an example, the second capillary structure 3 may have different capillary pore diameters. For example, a capillary pore diameter of a part, of the second capillary structure 3, in the second region 12 is greater than a capillary pore diameter of a part, of the second capillary structure 3, in the first region 11.

The second capillary structure 3 has a small capillary pore diameter in the first region 11 and has a large capillary pore diameter in the second region 12, so that a capillary force and a permeability of the second capillary structure 3 can be balanced, and the second capillary structure 3 has a large capillary force in the first region 11 and has a large permeability in the second region 12.

In this way, the liquid working fluid adsorbed by the second capillary structure 3 in the second region 12 can easily flow back to the first region 11, and the liquid working fluid is easily adsorbed in the first region 11.

In an example, to further balance the capillary force and the permeability, capillary pore diameters of the first capillary structure 2 and the second capillary structure 3 may alternatively be different correspondingly.

For example, the capillary pore diameter of the first capillary structure 2 may be greater than the capillary pore diameter of the second capillary structure 3. In an example, the second capillary structure 3 may use a large quantity of metal meshes (for example, copper meshes), and the first capillary structure 2 may use a wide-mesh metal mesh (for example, a copper mesh). A larger quantity of metal meshes indicates a smaller capillary pore diameter.

For another example, the capillary pore diameter of the first capillary structure 2 may be less than the capillary pore diameter of the second capillary structure 3.

In an example, as described above, the first capillary structure 2 may be the multi-layer stacked structure. In this case, the second capillary structure 3 may also be a multi-layer stacked structure, for example, may be a preformed multi-layer stacked structure.

A processing manner of the counter-layer stacked structure is similar to that described above. Examples are not described herein again.

Similarly, the second capillary structure 3 may also be made of foam metal, for example, foam copper. During manufacturing, the second capillary structure 3 with a large capillary pore diameter and a small capillary pore diameter may also be processed by using pore-forming agents with different pore diameters, so that the capillary pore diameter of the part, of the second capillary structure 3, in the second region 12 is greater than the capillary pore diameter of the part, of the second capillary structure 3, in the first region 11.

Certainly, the second capillary structure 3 may alternatively be a multi-layer stacked structure formed by a metal mesh (for example, a copper mesh), or may be a multi-layer stacked structure formed by a braided wire bundle made of a metal material, or may be a multi-layer stacked structure formed by metal powder (for example, copper powder) through sintering, or may be a counter-layer stacked structure formed by metal powder slurry (for example, copper powder slurry).

Based on the foregoing descriptions, a structure of the vapor chamber may be that the vapor chamber includes the first capillary structure, and the first capillary structure is located on the first inner surface a of the housing 1. Another structure of the vapor chamber may be that the vapor chamber includes the first capillary structure and the second capillary structure. The second capillary structure is sheet-shaped and laid on the first inner surface a. An area of the second capillary structure is equal to the area of the first inner surface a. The first capillary structure is strip-shaped and located on the surface of the second capillary structure.

The latter structure of the vapor chamber is used as an example. When the vapor chamber dissipates heat for the heat source, the liquid working fluid adsorbed by the first capillary structure and the second capillary structure in the first region is subject to phase transition after being heated, and evaporates into a gaseous working fluid. The gaseous working fluid flows to the second region with a low temperature, and condenses into a liquid working fluid when the gaseous working fluid cools. The liquid working fluid is adsorbed by the first capillary structure and the second capillary structure that are in the second region. Under an action of a capillary force, the liquid working fluid flows back to the first capillary structure and the second capillary structure that are in the first region, and waits for another phase transition to evaporate and be converted into a gaseous working fluid. Circulation is performed, to dissipate heat for the heat source.

In this embodiment of the present disclosure, the second part, of the first capillary structure, in the second region includes the trunk structure and the branch structure, and the branch structure includes at least one branch. In this way, the liquid working fluid in the second region can be adsorbed in the first capillary structure as much as possible, to prevent an unabsorbed liquid working fluid from freezing at a low temperature. Provided that there is no freezing phenomenon in the vapor chamber in a low-temperature environment, the housing of the vapor chamber basically does not bulge, so that the vapor chamber remains in a flat state, and the heat source in contact with the vapor chamber is not affected.

For example, if the branch structure corresponds to the region in which the cold source is located, the branch structure includes at least one branch, so that the liquid working fluid in the region in which the cold source is located can be adsorbed in the first capillary structure as much as possible, to prevent an unabsorbed liquid working fluid from freezing at a low temperature.

In addition, because the second part, of the first capillary structure, in the second region includes the trunk structure and the branch structure, and the branch structure further includes at least one branch, an area occupied by the first capillary structure in the second region can be increased, and an adsorption range in which the first capillary structure adsorbs the liquid working fluid in the second region can be increased, so that liquid working fluids at a large quantity of positions or even all positions in the second region can be adsorbed. This further reduces or even eliminates the unabsorbed liquid working fluid in the second region.

In addition, the first capillary structure adsorbs a large quantity of liquid working fluids in the second region, so that the liquid working fluid can be supplemented for the first region in time. In this way, a case in which no liquid working fluid can be evaporated in the first region is avoided, so that the liquid working fluid that can be evaporated always exists in the first region. This can improve heat dissipation effect of the vapor chamber.

An embodiment further provides a vapor chamber. As shown in FIG. 12, the vapor chamber still includes a housing 1, a first capillary structure 2, and a working fluid, and on this basis, further includes a third capillary structure 4. The first capillary structure 2, the working fluid, and the third capillary structure 4 are all located in the housing 1. An area of a projection, of the first capillary structure 2, on a first inner surface a of the housing 1 is less than an area of the first inner surface a, so that a cavity 10 can be formed in the housing 1. The working fluid in a liquid state is located in the first capillary structure 2 and the third capillary structure 4. The working fluid in a gaseous state is located in the cavity 10.

A region in the housing 1 includes a first region 11 and a second region 12. The first region 11 corresponds to a heat source. The second region 12 is different from the first region 11. The first capillary structure 2 includes a first part 21 located in the first region 11 and a second part 22 located in the second region 12. The third capillary structure 4 is located in the second region 12. The third capillary structure 4 is configured for an adsorbed liquid working fluid to flow to the first region 11.

In an example, for a structure of the housing 1, refer to the foregoing descriptions. Details are not described herein again. A feature of the first capillary structure 2 may be a structural feature shown in FIG. 12, or may be the foregoing feature of the first capillary structure 2.

As shown in FIG. 12, not only the second part of the first capillary structure is disposed in the second region, but also the third capillary structure is disposed in the second region. An area occupied by capillary structures in the second region is large. In this way, a liquid working fluid in the second region can be adsorbed in the first capillary structure as much as possible, to prevent an unabsorbed liquid working fluid from freezing at a low temperature. Provided that there is no freezing phenomenon in the vapor chamber in a low-temperature environment, the housing of the vapor chamber basically does not bulge, so that the vapor chamber remains in a flat state, and the heat source in contact with the vapor chamber is not affected.

In an example, the third capillary structure is in contact with or close to the second part, so that a liquid working fluid adsorbed by the third capillary structure can flow back to the first part in the first region through the second part.

In an example, the vapor chamber may further include a second capillary structure 3. For a feature of the second capillary structure 3, refer to the foregoing descriptions. As shown in FIG. 12, the second capillary structure 3 is located on the first inner surface a, and a projection area, of the second capillary structure 3, on the first inner surface a is equal to the area of the first inner surface a. In other words, the second capillary structure 3 covers all positions of the first inner surface a. In FIG. 12, a grid-filled part is an example of the second capillary structure 3 located on the first inner surface a.

Both the first capillary structure 2 and the third capillary structure 4 are located on a surface of the second capillary structure 3, and the liquid working fluid may flow in the first capillary structure 2, the third capillary structure 4, and the second capillary structure 3.

For a feature of the second capillary structure 3, refer to the foregoing descriptions. Details are not described herein again.

An embodiment further provides an electronic device. The electronic device may be a mobile phone, a notebook computer, a tablet computer, or the like. The electronic device includes a heat source and the foregoing vapor chamber. An outer surface of a first housing wall of the vapor chamber is in contact with an outer surface of the heat source at a position corresponding to a first region. The first housing wall is a housing wall corresponding to a first inner surface a. For example, the first housing wall is a housing wall on which the first inner surface is located.

In an example, a thermal interface material (thermal interface material, TIM) may also be filled between the first housing wall of the vapor chamber and the heat source, to eliminate a contact gap between the vapor chamber and the heat source, improve heat transfer between the vapor chamber and the heat source, and improve heat dissipation effect for heat dissipation of the heat source.

In an example, the electronic device may further include a cold source. The cold source may be a fan. A second region of the vapor chamber may be adjacent to the fan, and heat released through condensation in the second region is absorbed through air cooling.

As described above, a second part, of a first capillary structure of the vapor chamber of the electronic device, in the second region includes a trunk structure and a branch structure, and the branch structure further includes at least one branch. In this way, a liquid working fluid in the second region can be adsorbed in the first capillary structure as much as possible, to prevent an unabsorbed liquid working fluid from freezing at a low temperature. Provided that there is no freezing phenomenon in the vapor chamber in a low-temperature environment, the housing of the vapor chamber basically does not bulge, so that the vapor chamber remains in a flat state, and the heat source in contact with the vapor chamber is not affected.

For example, if the branch structure corresponds to a region in which the cold source is located, the branch structure includes at least one branch, so that a liquid working fluid in the region in which the cold source is located can be adsorbed in the first capillary structure as much as possible, to prevent an unabsorbed liquid working fluid from freezing at a low temperature.

In addition, because the second part, of the first capillary structure, in the second region includes the trunk structure and the branch structure, and the branch structure further includes at least one branch, an area occupied by the first capillary structure in the second region can be increased, and an adsorption range in which the first capillary structure adsorbs the liquid working fluid in the second region can be increased, so that liquid working fluids at a large quantity of positions or even all positions in the second region can be adsorbed. This further reduces or even eliminates the unabsorbed liquid working fluid in the second region.

In addition, the first capillary structure adsorbs a large quantity of liquid working fluids in the second region, so that the liquid working fluid can be supplemented for the first region in time. In this way, a case in which no liquid working fluid can be evaporated in the first region is avoided, so that the liquid working fluid that can be evaporated always exists in the first region. This can improve heat dissipation effect of the vapor chamber.

The foregoing descriptions are merely an embodiment of the present disclosure, but are not intended to limit the present disclosure. Any modification, equivalent replacement, or improvement made without departing from the spirit and principle of the present disclosure shall fall within the protection scope of the present disclosure.

## Claims

1. A vapor chamber, wherein the vapor chamber comprises a housing (1), a first capillary structure (2), and a working fluid;
both the first capillary structure (2) and the working fluid are located in the housing (1), an area of a projection, of the first capillary structure (2), on a first inner surface (a) of the housing (1) is less than an area of the first inner surface (a), the housing (1) has a cavity (10), the working fluid is converted between a gaseous state and a liquid state, the working fluid in the liquid state is located in the first capillary structure (2), and the working fluid in the gaseous state is located in the cavity (10); and
a region in the housing (1) comprises a first region (11) and a second region (12), the first region (11) corresponds to a region in which a heat source is located, the second region (12) is different from the first region (11), the first capillary structure (2) comprises a first part (21) located in the first region (11) and a second part (22) located in the second region (12), the second part (22) comprises a trunk structure (221) and a branch structure (222), the trunk structure (221) is connected to the first part (21), the branch structure (222) corresponds to a region in which a cold source is located, the branch structure (222) comprises at least one branch (223), and each branch (223) is in contact with or close to the trunk structure (221).

2. The vapor chamber according to claim 1, wherein each branch (223) comprises at least two sub-branches (224), and each sub-branch (224) is connected to a branch (223) to which the sub-branch (224) belongs.

3. The vapor chamber according to claim 1 or 2, wherein a capillary pore diameter of the second part (22) located in the second region (12) is greater than a capillary pore diameter of the first part (21) located in the first region (11).

4. The vapor chamber according to any one of claims 1 to 3, wherein a projection area, of the first part (21), on a surface that is of the first inner surface (a) and that is located in the first region (11) is greater than a non-projection area, and the non-projection area is greater than zero.

5. The vapor chamber according to any one of claims 1 to 3, wherein a projection area, of the first part (21), on a surface that is of the first inner surface (a) and that is located in the first region (11) is equal to an area, of the first part (21), on the surface that is of the first inner surface (a) and that is located in the first region (11).

6. The vapor chamber according to any one of claims 1 to 5, wherein there are a plurality of second regions (12), and the second part (22) is disposed in each second region (12).

7. The vapor chamber according to claim 6, wherein the vapor chamber comprises at least two first capillary structures (2); and
first parts (21) of the at least two first capillary structures (2) are located in the first region (11), and a second part (22) of each first capillary structure (2) is located in one second region (12).

8. The vapor chamber according to claim 7, wherein the first parts (21) of the at least two first capillary structures (2) have an overlapping part in a direction parallel to the first inner surface (a).

9. The vapor chamber according to claim 7, wherein the first parts (21) of the at least two first capillary structures (2) are spaced from each other in a direction parallel to the first inner surface (a).

10. The vapor chamber according to any one of claims 1 to 9, wherein there is a gap between the first capillary structure (2) and a second inner surface (b) of the housing (1), and the second inner surface (b) is an inner surface that is positioned opposite to the first inner surface (a).

11. The vapor chamber according to any one of claims 1 to 4 or claims 6 to 10, wherein the vapor chamber further comprises a second capillary structure (3);
the second capillary structure (3) completely covers the first inner surface (a); and
the first capillary structure (2) is located on a surface of the second capillary structure (3), and the working fluid in the liquid state is located in the first capillary structure (2) and the second capillary structure (3).

12. The vapor chamber according to claim 11, wherein a capillary pore diameter of a part, of the second capillary structure (3), in the second region (12) is greater than a capillary pore diameter of a part, of the second capillary structure (3), in the first region (11).

13. The vapor chamber according to claim 11 or 12, wherein a capillary pore diameter of the first capillary structure (2) is different from a capillary pore diameter of the second capillary structure (3).

14. The vapor chamber according to any one of claims 11 to 13, wherein the second capillary structure (3) is made of foam metal.

15. The vapor chamber according to any one of claims 1 to 14, wherein the first capillary structure (2) is made of foam metal.

16. The vapor chamber according to any one of claims 1 to 15, wherein the first capillary structure (2) is a multi-layer stacked structure.

17. The vapor chamber according to any one of claims 11 to 14, wherein the second capillary structure (3) is a multi-layer stacked structure.

18. The vapor chamber according to claim 16 or 17, wherein the multi-layer stacked structure is preformed.

19. The vapor chamber according to any one of claims 16 to 18, wherein a processing manner of the multi-layer stacked structure is one of calendering, silk-screen printing, 3D printing, and electroplating.

20. An electronic device, wherein the electronic device comprises a heat source and the vapor chamber according to any one of claims 1 to 19, a first housing wall of the vapor chamber is in contact with the heat source at a position corresponding to the first region (11), and the first housing wall is a housing wall corresponding to the first inner surface (a).
